# EUROPÄISCHE PATENTSCHRIFT

(11) **EP 4 073 892 B1**
(45) Veröffentlichungstag und Bekanntmachung des Hinweises auf die Patenterteilung: **04.10.2023**
(21) Anmeldenummer: 20806973.2
(22) Anmeldetag: 11.11.2020
(51) Int. Cl.: H01T 4/16, H01T 15/00

(54) **VORRICHTUNG ZUR ABLEITUNG VON ÜBERSPANNUNGEN UND DEREN VERWENDUNG**
DEVICE FOR DISSIPATING SURGES AND USE THEREOF
DISPOSITIF DE DISSIPATION DE SURTENSIONS ET SON UTILISATION

(30) Priorität: 13.12.2019 DE 102019134337
(43) Veröffentlichungstag der Anmeldung: 19.10.2022
(73) Patentinhaber: TDK Electronics AG, 81671 München (DE)
(72) Erfinder: DORSCH, Eduard, 14624 Dallgow (DE); WERNER, Frank, 13591 Berlin (DE)
(74) Vertreter: Epping - Hermann - Fischer
(86) Internationale Anmeldenummer: PCT/EP2020/081730
(87) Internationale Veröffentlichungsnummer: WO 2021/115709

(56) Entgegenhaltungen:
- WO-A1-2009/050152
- WO-A1-2017/129291
- DE-A1-102008 029 094
- DE-A1-102009 049 579
- DE-A1-102015 114 504
- US-A- 3 848 156

## Beschreibung

Es wird eine Vorrichtung zur Ableitung von Überspannungen angegeben. Weiterhin wird die Verwendung der Vorrichtung in einem elektrischen Gerät oder in einem elektrischen Netz angegeben.

Um gefährliche oder unerwünschte Überspannungen in elektrischen Leitungen und Geräten zu begrenzen, die beispielsweise durch Blitzeinschläge verursacht werden können, werden Überspannungsschutzeinrichtungen in Form von Überspannungsableitern eingesetzt. Diese helfen, durch Überspannungen hervorgerufene Schädigungen der Leitungen und Geräte zu vermeiden. Beispielsweise gibt es mit Gas gefüllte Überspannungsableiter, sogenannte Gasableiter, bei denen eine Überspannung durch das selbsttätige Zünden einer Gasentladung und somit durch eine Lichtbogenentladung abgebaut wird. Nach Erreichen einer Ableiteransprechspannung, die auch als Ansprechspannung oder als Zündspannung bezeichnet werden kann, durch eine am Ableiter anliegenden Überspannung, beispielsweise in Form eines Überspannungsimpuls, bildet sich innerhalb von Nanosekunden im Ableiter ein Lichtbogen. Durch dessen hohe Stromtragfähigkeit wird die Überspannung effektiv kurzgeschlossen.

Die Ansprechspannung wird bei statischer oder stationärer Beanspruchung, beispielsweise mit einem Spannungsanstieg in einer Größenordnung von 100 V/s, auch als Ansprechgleichspannung bezeichnet. Bei dynamischer Belastung, etwa mit einem Spannungsanstieg in einer Größenordnung von 1 kV/ps, wird die Ansprechspannung auch als Ansprechstoßspannung bezeichnet. Die Ansprechgleichspannung und der Schutzpegel, d.h. die Ansprechstoßspannung, sind bei Gasableitern proportional zueinander. Wenn die Ansprechgleichspannung gesenkt werden kann, wird auch der Schutzpegel kleiner. Entsprechend kann auch die Ansprechgleichspannung eines Mehrstreckenableiters reduziert werden, um dessen Schutzpegel zu senken.

Ein Gasableiter schaltet mit der Erzeugung des Lichtbogens in einen leitenden Zustand, der auch als "arc mode" bezeichnet werden kann. Die Bogenbrennspannung im Gasableiter, auch als "arc voltage" bezeichnet, kann üblicherweise in einem Größenordnungsbereich von 10 V bis 100 V liegen, abhängig vom Strom und von der Art des Gasableiters. Wenn die am Gasableiter anliegende Spannung unter die Bogenbrennspannung fällt, verlöscht der Lichtbogen selbstständig. Wenn die Spannungsversorgung, an der der Gasableiter abgeschlossen ist, jedoch eine Netzspannung liefert, die höher als die Bogenbrennspannung ist, entsteht ein sogenannter Folgestrom, durch den der Lichtbogen aufrechterhalten werden kann. Beispielsweise kann die Netzspannung eine übliche Wechselspannung von 255 V_{ac} sein. Nur durch den Spannungsnulldurchgang der Wechselspannungssinuskurve kann der Folgestrom im Gasableiter gelöscht werden. Bei einer durch eine Gleichspannung gebildeten Netzspannung kann es sogar sein, dass der Lichtbogen und der damit einhergehende Stromfluss ohne weiteres nicht zum Erlöschen kommen, wenn die Gleichspannung über der Bogenbrennspannung liegt. Dies ist erst der Fall, wenn die am Gasableiter anliegende Spannung unter dessen Bogenbrennspannung sinkt, die der anliegenden Gleichspannung entgegenwirkt. Falls die Stromstärke des Folgestroms einige Kiloampere beträgt, wird die Sicherung der Spannungsversorgung zwar in diesem Fall ansprechen, bei üblichen Stromflussdauern von einigen Millisekunden bis zum Ansprechen der Sicherung kann der Gasableiter jedoch beschädigt werden.

Um die Spannung, bei der der Lichtbogen in einer Überspannungsschutzeinrichtung erlischt, zu erhöhen, können beispielsweise mehrere gleichartige Gasableiter in Reihe geschaltet werden, sodass sich die Bogenbrennspannungen summieren. Allerdings erhöht sich dadurch auch die Ansprechspannung, die erforderlich ist, um alle Gasableiter zu zünden, und damit der Schutzpegel der Überspannungsschutzeinrichtung, da die Zündspannung, bei der die Gasableiter einer Reihenschaltung von Gasableitern zünden, proportional zur Anzahl der Gasableiter ist.

Die Druckschrift DE 10 2008 029094 A1 beschreibt eine Reihenschaltung von mehreren Ableitern mit unterschiedlichen Ansprechgleichspannungen. Die Druckschrift DE 10 2009 049579 A1 beschreibt eine Reihenschaltung von zwei Gasableitern, deren Gasfüllung zwischen den Gasableitern zirkulierbar ist.

Zumindest eine Aufgabe von bestimmten Ausführungsformen ist es, eine Vorrichtung zur Ableitung von Überspannungen anzugeben. Eine weitere Aufgabe von bestimmten Ausführungsformen ist es, eine Verwendung für die Vorrichtung zur Ableitung von Überspannungen anzugeben.

Diese Aufgaben werden durch Gegenstände gemäß den unabhängigen Patentansprüchen gelöst. Vorteilhafte Ausführungsformen und Weiterbildungen der Gegenstände sind in den abhängigen Ansprüchen gekennzeichnet und gehen weiterhin aus der nachfolgenden Beschreibung und den Zeichnungen hervor.

Gemäß zumindest einer Ausführungsform weist eine Vorrichtung zur Ableitung von Überspannungen, die im Folgenden auch kurz als Ableitungsvorrichtung oder Vorrichtung bezeichnet werden kann, eine erste Ableitereinheit mit zumindest einem ersten gasgefüllten Überspannungsableiter und eine zweite Ableitereinheit mit zumindest einem zweiten gasgefüllten Überspannungsableiter auf, die zwischen einem ersten Potenzialknoten und einem Bezugspotenzialknoten miteinander in Reihe geschaltet sind. Im Folgenden werden die gasgefüllten Überspannungsableiter auch kurz als Überspannungsableiter oder Gasableiter bezeichnet. Jeder der Gasableiter weist ein geschlossenes, gasgefülltes Volumen in auf, in dem zumindest zwei Elektroden angeordnet sind, zwischen denen bei einer ausreichend hohen anliegenden elektrischen Spannung eine Gasentladung, insbesondere unter Bildung eines Lichtbogens, stattfinden kann.

Gemäß einer weiteren Ausführungsform wird die Vorrichtung zur Ableitung von Überspannungen in einem elektrischen Gerät oder in einem elektrischen Netz verwendet. Das elektrische Netz kann ein Wechselstromnetz oder ein Gleichstromnetz sein. Weiterhin kann das elektrische Gerät ein Wechselstromgerät oder ein Gleichstromgerät sein. Die vorab und im Folgenden beschriebenen Merkmale gelten gleichermaßen für die Vorrichtung wie auch für die Verwendung der Vorrichtung.

Der Bezugspotentialknoten entspricht besonders bevorzugt einem Schutzleiter bzw. PE-Leiter oder einem Neutralleiter bzw. N-Leiter. Der erste Potentialknoten entspricht vorzugsweise einer Phase bzw. einem L-Leiter. Entsprechend sind die erste und zweite Ableitereinheit bevorzugt zwischen einem L-Leiter und einem N-Leiter oder zwischen einem L-Leiter und einem PE-Leiter in Reihe geschaltet. Weiterhin ist auch denkbar, dass der erste Potentialknoten einem N-Leiter und der Bezugspotentialknoten einem PE-Leiter entspricht.

Insbesondere sind die erste Ableitereinheit und die zweite Ableitereinheit verschieden voneinander. Besonders bevorzugt bedeutet das, dass die erste Ableitereinheit und die zweite Ableitereinheit unterschiedliche gasgefüllte Überspannungsableiter aufweisen. Entsprechend sind besonders bevorzugt der erste Überspannungsableiter und der zweite Überspannungsableiter unterschiedlich zueinander. Dass zwei Überspannungsableiter unterschiedlich zueinander sind, kann insbesondere bedeuten, dass sich die Überspannungsableiter in zumindest einem oder mehreren der folgenden Merkmale unterscheiden: Gasart, Gasdruck, Gasvolumen, Elektrodenmaterial, Elektrodengeometrie, Elektrodenabstand, Elektrodenanzahl, interne Zündhilfe.

Gemäß einer weiteren Ausführungsform weist zumindest eine der Ableitereinheiten der Vorrichtung mehr als einen gasgefüllten Überspannungsableiter auf. Beispielsweise kann eine Mehrzahl von gasgefüllten Überspannungsableitern größer oder gleich 4 oder größer oder gleich 5 oder größer oder gleich 10 oder größer oder gleich 12 oder größer oder gleich 20 gasgefüllte Überspannungsableiter aufweisen. Eine Ableitereinheit mit einer Mehrzahl von Gasableitern ist entsprechend als Mehrstreckenableiter ausgebildet. Die Überspannungsableiter der Mehrzahl der Überspannungsableiter einer Ableitereinheit sind bevorzugt in Reihe geschaltet.

Besonders bevorzugt weist die zweite Ableitereinheit eine Mehrzahl von zweiten Überspannungsableitern auf, die miteinander in Reihe geschaltet sind. Besonders vorteilhaft ist es, wenn alle Überspannungsableiter der ersten und zweiten Ableitereinheit, also alle ersten Gasableiter und alle zweiten Gasableiter, in Reihe miteinander geschaltet sind. Weiterhin kann die zweite Ableitereinheit zumindest eine Triggerschaltung aufweisen, um eine Synchronzündung oder zumindest eine im Wesentlichen synchrone Zündung der zweiten Überspannungsableiter zu ermöglichen. Eine Triggerschaltung kann beispielsweise durch ein weiter unten beschriebenes RC-Glied gebildet werden oder ein solches aufweisen.

Gemäß einer weiteren Ausführungsform weist die erste Ableitereinheit genau einen ersten Überspannungsableiter auf. Das kann insbesondere bedeuten, dass die erste Ableitereinheit genau einen gasgefüllten Überspannungsableiter aufweist, der der erste Überspannungsableiter ist. Besonders bevorzugt ist der genau eine erste Überspannungsableiter mit allen zweiten Überspannungsableitern in Reihe geschaltet.

Gemäß einer weiteren Ausführungsform weist die erste Ableitereinheit eine größere Ansprechspannung auf als die zweite Ableitereinheit. Das kann insbesondere bedeuten, dass der erste Überspannungsableiter der ersten Ableitereinheit eine größere Ansprechspannung als der zweite Überspannungsableiter aufweist. Weist die erste Ableitereinheit eine Mehrzahl von ersten Überspannungsableitern auf, gelten die vorab und im Folgenden beschriebenen Merkmale besonders bevorzugt für jeden ersten Überspannungsableiter. Weiterhin weist die erste Ableitereinheit besonders bevorzugt eine Ansprechspannung auf, die größer als eine Netzspannung zum Betrieb des elektrischen Geräts oder des elektrischen Netzes ist. Dies gilt besonders bevorzugt für den zumindest einen ersten Überspannungsableiter der ersten Ableitereinheit.

Weist die zweite Ableitereinheit eine Mehrzahl von zweiten Überspannungsableitern auf, weist besonders bevorzugt der erste Überspannungsableiter der ersten Ableitereinheit eine größere Ansprechspannung als jeder zweite Überspannungsableiter der zweiten Ableitereinheit auf. Bevorzugt weist die erste Ableitereinheit weiterhin eine kleinere Bogenbrennspannung als die zweite Ableitereinheit auf. Insbesondere kann die zweite Ableitereinheit eine Mehrzahl von zweiten Überspannungsableitern aufweisen, deren Reihenschaltung eine größere Bogenbrennspannung als die erste Ableitereinheit und insbesondere als der erste gasgefüllte Überspannungsableiter aufweist. Die zweite Ableitereinheit kann beispielsweise eine Ansprechspannung aufweisen, die kleiner als eine Netzspannung zum Betrieb des elektrischen Geräts oder des elektrischen Netzes ist.

Gemäß einer weiteren Ausführungsform ist von wenigstens einem Potenzialknoten zwischen zwei benachbarten zweiten Überspannungsableitern ein RC-Glied zum Bezugspotenzialknoten gekoppelt. Weiterhin kann alternativ oder zusätzlich von einem Potenzialknoten zwischen einem ersten Überspannungsableiter und einem benachbarten zweiten Überspannungsableiter ein RC-Glied zum Bezugspotenzialknoten gekoppelt sein.

Gemäß einem Ausführungsbeispiel ist jedem zweiten Überspannungsableiter ein RC-Glied zugeordnet. Weist die zweite Ableitereinheit eine Anzahl N von zweiten Überspannungsableitern auf, so sind in diesem Fall auch N RC-Glieder vorgesehen. Ein RC-Glied ist einem Überspannungsableiter zugeordnet, wenn der Potenzialknoten, von dem das RC-Glied zum Bezugspotentialknoten gekoppelt ist, unmittelbar auf der dem ersten Potenzialkonten zugewandten Seite des betreffenden Überspannungsableiters angeordnet ist.

Gemäß einem weiteren Ausführungsbeispiel ist von jedem Potenzialknoten zwischen zwei benachbarten Überspannungsableitern, also insbesondere allen ersten und zweiten Überspannungsableitern der ersten und zweiten Ableitereinheit, jeweils ein RC-Glied mit parallel geschaltetem Widerstand und Kondensator zum Bezugspotenzialknoten gekoppelt. Weisen die erste und zweite Ableitereinheit zusammen eine Anzahl N von Überspannungsableitern auf, so sind N-1 RC-Glieder vorgesehen.

Ein RC-Glied und bevorzugt jedes RC-Glied der Vorrichtung kann parallel zueinander geschaltet einen Widerstand und einen Kondensator aufweisen oder daraus bestehen. Entsprechend weisen die Vorrichtung und insbesondere die zweite Ableitereinheit wenigstens ein RC-Glied und vorzugsweise eine Mehrzahl von RC-Gliedern auf. Beispielsweise können die Vorrichtung und insbesondere die zweite Ableitereinheit beispielsweise 2, 3, 4, 5 oder 10 RC-Glieder aufweisen. Jedes RC-Glied kann direkt und insbesondere ohne weitere zwischengeschaltete elektrische Komponente zum Bezugspotenzialknoten gekoppelt sein. Jedes RC-Glied ist jeweils zu wenigstens einem Überspannungsableiter parallel geschaltet.

Durch den parallel zum Kondensator geschalteten Widerstand eines RC-Glieds wird der Kondensator nach einem Stoßstrom innerhalb kurzer Zeit durch den Widerstand entladen. Die Ansprechspannung des zugeordneten Überspannungsableiters kann dadurch konstant niedrig bleiben. Außerdem kann die Ansprechspannung mit der Kondensator-Widerstand-Kombination auch beim ersten Ansprechen niedriger sein als beispielsweise ohne Widerstand nur mit einem Kondensator.

Gemäß einem Ausführungsbeispiel weist die Vorrichtung Gruppen von Überspannungsableitern auf. Eine Gruppe kann 2, 3 oder mehr Überspannungsableiter aufweisen. Die Vorrichtung kann zwei, drei oder mehr Gruppen aufweisen. Von einem Potenzialknoten zwischen den einzelnen Gruppen kann jeweils ein RC-Glied mit parallel geschaltetem Widerstand und Kondensator zum Bezugspotenzialknoten gekoppelt sein. Eine Gruppe von Überspannungsableitern kann beispielsweise durch einen als Mehrstreckenableiter ausgebildeten Überspannungsableiter gebildet sein, der mehrere in Serie geschaltete Funkenstrecken in einer baulichen Einheit aufweist.

Gemäß einem weiteren Ausführungsbeispiel beträgt die Zeitkonstante τ eines RC-Glieds und insbesondere jedes RC-Glieds weniger oder gleich 1 ms. Damit kann eine schnelle Entladung des Kondensators sichergestellt und die Ansprechstoßspannung niedrig gehalten werden.

Gemäß einem weiteren Ausführungsbeispiel liegt die Kapazität C des Kondensators eines RC-Glieds und insbesondere jedes RC-Glieds zwischen 1 nF und 40 nF, wobei die Grenzen jeweils eingeschlossen sind. Je höher dabei die Kapazität ist, desto höher sind die Durchschaltzeit und damit die Reaktionszeit des zugeordneten Überspannungsableiters und die Ansprechspannung sinkt.

Gemäß einem weiteren Ausführungsbeispiel liegt der Widerstand R eines RC-Glieds und insbesondere jedes RC-Glieds zwischen 1 kΩ und 100 kQ, wobei die Grenzen jeweils eingeschlossen sind. Je kleiner dabei der Widerstandswert ist, desto länger dauert das Laden des Kondensators während eines Stromimpulses und die Durchschaltzeit steigt.

Gemäß einer weiteren Ausführungsform weist die Vorrichtung zum Ableitung von Überspannungen eine weitere erste Ableitereinheit mit zumindest einem ersten gasgefüllten Überspannungsableiter und zumindest eine weitere zweite Ableitereinheit mit zumindest einem zweiten gasgefüllten Überspannungsableiter auf, wobei die weitere erste Ableitereinheit und die weitere zweite Ableitereinheit zwischen einem zweiten Potenzialknoten und dem Bezugspotenzialknoten miteinander in Reihe geschaltet sind. Die vorab für die erste und zweite Ableitereinheit sowie für deren Überspannungsableiter beschriebenen Merkmale können bevorzugt auch für die weitere erste Ableitereinheit und die weitere zweite Ableitereinheit sowie deren Überspannungsableiter gelten. Besonders bevorzugt sind die ersten Ableitereinheiten, also die erste Ableitereinheit und die weitere erste Ableitereinheit, gleich. Besonders bevorzugt sind auch die zweiten Ableitereinheiten, also die zweite Ableitereinheit und die weitere zweite Ableitereinheit, gleich. Dass zwei Ableitereinheiten gleich sind, kann insbesondere bedeuten, dass sie die gleichen Komponenten aufweisen. Der zweite Potenzialknoten kann einer Phase bzw. einem L-Leiter entsprechen. Beispielsweise können der erste und zweite Potenzialkonten in diesem Fall zwei Phasen entsprechen, also etwa L+ und L-.

Gemäß einer weiteren Ausführungsform sind die Überspannungsableiter der ersten und zweiten Ableitereinheit zusammen als einstückiger Mehrstreckenableiter ausgebildet. Mit anderen Worten sind der zumindest eine erste Überspannungsableiter und der zumindest eine zweite Überspannungsableiter als zusammenhängendes Bauelement ausgebildet, in das die ersten und zweiten Überspannungsableiter als bauliche Einheit integriert sind. Entsprechend können auch die Überspannungsableiter der weiteren ersten und weiteren zweiten Ableitereinheit zusammen als einstückiger Mehrstreckenableiter ausgebildet sein. Entsprechend können die Überspannungsableiter der ersten und zweiten Ableitereinheit und die Überspannungsableiter der weiteren ersten und weiteren zweiten Ableitereinheit zusammen als mehrstückiger Mehrstreckenableiter ausgebildet sind. Besonders bevorzugt können die Überspannungsableiter der ersten und zweiten Ableitereinheit und die Überspannungsableiter der weiteren ersten und weiteren zweiten Ableitereinheit zusammen als einstückiger Mehrstreckenableiter ausgebildet sein. Das kann insbesondere bedeuten, dass alle Überspannungsableiter der Vorrichtung in einem gemeinsamen Bauelement integriert sind.

Beispielsweise kann die hier beschriebene Vorrichtung in einer Telekommunikationseinrichtung, beispielsweise einem Telekommunikationsnetzwerk, verwendet werden. Weiterhin kann die Vorrichtung in einem Wechselstrom- oder Gleichstromnetz verwendet werden. Darüber hinaus kann die Vorrichtung auch in jeder anderen elektrischen Schaltung verwendet werden, in der Spannungen mittels Überspannungsableiter abgeführt werden müssen.

Besonders bevorzugt ist bei der hier beschriebenen Vorrichtung zur Ableitung von Überspannungen die erste Ableitereinheit so ausgebildet, dass die erste Ableitereinheit hohe Blitzstromstöße tragen kann, besonders bevorzugt insbesondere (10/350ps) Stromimpulse, ohne ihre Eigenschaften, insbesondere die Ansprechspannung, also die Ansprechgleichspannung und/oder die Ansprechstoßspannung, und damit den Schutzpegel, zu verändern. Insbesondere wird die zweite Ableitereinheit besonders bevorzugt so ausgebildet, dass deren Ansprechspannung und damit deren Schutzpegel möglichst niedrig sind. Besonders bevorzugt ist die Ansprechspannung und insbesondere die Ansprechgleichspannung der zweiten Ableitereinheit kleiner als die die Netzspannung. Um die als Mehrstreckenableiter ausgebildete zweite Ableitereinheit an einer Netzspannung betreiben zu können, ist zusätzlich die erste Ableitereinheit vorgesehen, die den zumindest einen erste Überspannungsableiter aufweist, der bevorzugt ein robustes Innendesign aufweist und dessen Ansprechspannung und insbesondere dessen Ansprechgleichspannung größer als die Netzspannung ist. Die erste Ableitereinheit und insbesondere der erste Überspannungsableiter trennt die zweite Ableitereinheit und damit die restliche Strecken der als Mehrstreckenableiter ausgebildeten Vorrichtung von der Netzspannung, so dass eine Zündung der zweiten Überspannungsableiter im Normalbetrieb verhindert wird. Dabei ist es bevorzugt, wenn die Ansprechspannung der ganzen Ableitungsvorrichtung im Wesentlichen durch die erste Ableitereinheit bestimmt wird, deren Ansprechspannung wie beschrieben größer als die Netzspannung ist. Weiterhin ist besonders bevorzugt die zweite Ableitereinheit so ausgebildet, dass deren Bogenbrennspannung größer als die der ersten Ableitereinheit ist, so dass durch die zweite Ableitereinheit ein Netzfolgestrom reduziert und besonders bevorzugt gelöscht werden kann. Bei der hier beschriebenen Vorrichtung ermöglichst es die Kombination von unterschiedlichen Gasableitern bzw. Ableitereinheiten mit unterschiedlichen Eigenschaften somit, die gewünschten Vorteile der einzelnen Gasableiter bzw. Ableitereinheiten in der als Mehrstreckenableiter ausgebildeten Ableitungsvorrichtung zu vereinen.

Weitere Vorteile, vorteilhafte Ausführungsformen und Weiterbildungen ergeben sich aus den im Folgenden in Verbindung mit den Figuren beschriebenen Ausführungsbeispielen.

Es zeigen:
Figur 1 eine schematische Darstellungen einer Vorrichtung zur Ableitung von Überspannungen gemäß einem Ausführungsbeispiel,
Figur 2 eine schematische Darstellung einer Vorrichtung zur Ableitung von Überspannungen gemäß einem weiteren Ausführungsbeispiel,
Figur 3 eine schematische Darstellung eines einstückigen Mehrstreckenableiters einer Vorrichtung zur Ableitung von Überspannungen gemäß einem weiteren Ausführungsbeispiel,
Figur 4 eine schematische Darstellung einer Vorrichtung zur Ableitung von Überspannungen gemäß einem weiteren Ausführungsbeispiel und
Figur 5 eine schematische Darstellung eines einstückigen Mehrstreckenableiters einer Vorrichtung zur Ableitung von Überspannungen gemäß einem weiteren Ausführungsbeispiel.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

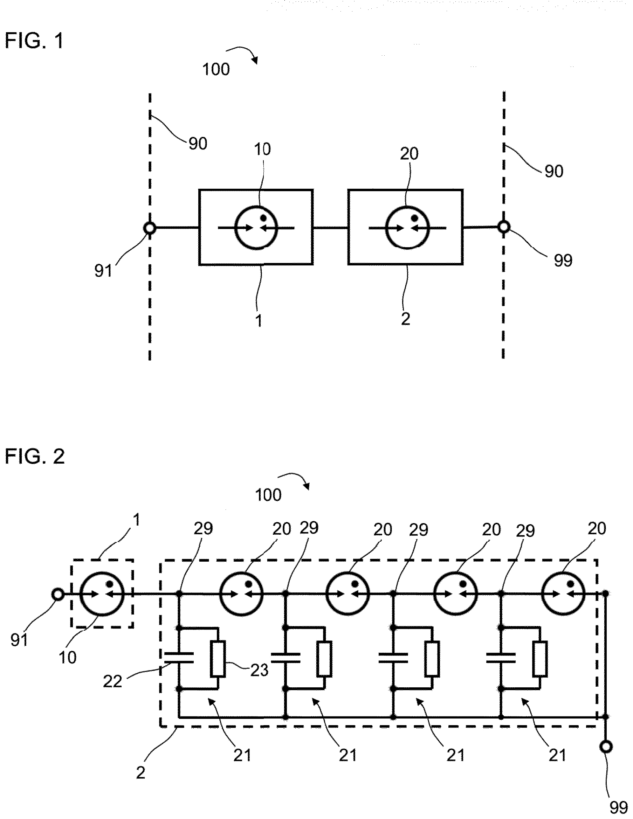

In Figur 1 ist ein Ausführungsbeispiel für eine Vorrichtung 100 zur Ableitung von Überspannungen gezeigt. Die Vorrichtung 100 wird in einem elektrischen Gerät und/oder in einem elektrischen Netz verwendet, dessen Leiter 90 mit den gestrichelten Linien angedeutet sind. Zusätzlich zu den zwei angedeuteten Leitern 90 können noch mehr Leiter vorhanden sein. Beispielsweise können die Leiter 90 Teil eines Wechselstromnetzes oder eines Gleichstromnetzes sein.

Die Vorrichtung 100 weist eine erste Ableitereinheit 1 und eine zweite Ableitereinheit 2 auf, die zwischen einem ersten Potenzialknoten 91 und einem Bezugspotenzialknoten 99 in Reihe geschaltet sind. Der Bezugspotentialknoten 99 entspricht beispielsweise einem Schutzleiter bzw. PE-Leiter oder einem Neutralleiter bzw. N-Leiter, während der erste Potentialknoten 91 vorzugsweise einer Phase bzw. einem L-Leiter entspricht, so dass die erste und zweite Ableitereinheit 1, 2 zwischen einem L-Leiter und einem N-Leiter oder zwischen einem L-Leiter und einem PE-Leiter in Reihe geschaltet sind. Alternativ kann der erste Potentialknoten 91 beispielsweise auch einem N-Leiter und der Bezugspotentialknoten 99 einem PE-Leiter entsprechen.

Die erste Ableitereinheit 1 weist zumindest einen ersten gasgefüllten Überspannungsableiter 10 auf, während die zweite Ableitereinheit 2 zumindest einen zweiten gasgefüllten Überspannungsableiter 20 aufweist, die zwischen dem ersten Potenzialknoten 91 und dem Bezugspotenzialknoten 99 miteinander in Reihe geschaltet sind. Die Vorrichtung 100 ist somit als Mehrstreckenableiter ausgebildet. Die Verschaltung der Überspannungsableiter 10, 20 ist in Figur 1 nur angedeutet. Eine bevorzugte Verschaltung ist beispielsweise in Figur 2 gezeigt.

Die erste Ableitereinheit 1 und die zweite Ableitereinheit 2 sind verschieden voneinander. Insbesondere weisen die erste Ableitereinheit 1 und die zweite Ableitereinheit 2 unterschiedliche gasgefüllte Überspannungsableiter auf, so dass der zumindest eine erste Überspannungsableiter 10 und der zumindest eine zweite Überspannungsableiter 20 unterschiedlich zueinander sind.

Die erste Ableitereinheit 1 und die zweite Ableitereinheit 2 sind so ausgebildet, dass die erste Ableitereinheit 1 eine größere Ansprechspannung als die zweite Ableitereinheit 2 aufweist. Dies kann für die Ansprechgleichspannung oder für die Ansprechstoßspannung oder bevorzugt für beide gelten. Insbesondere kann der zumindest eine erste Überspannungsableiter 10 der ersten Ableitereinheit 1 eine größere Ansprechspannung als der zumindest eine zweite Überspannungsableiter 2 der zweiten Ableitereinheit 2 aufweisen. Dabei weist die erste Ableitereinheit 1 besonders eine Ansprechspannung auf, die größer als eine Netzspannung zwischen den Leitern 90, also zwischen dem ersten Potenzialknoten 91 und dem Bezugspotenzialknoten 99, ist und damit größer als eine Netzspannung zum Betrieb des elektrischen Geräts oder des elektrischen Netzes. Dies gilt besonders bevorzugt für den zumindest einen ersten Überspannungsableiter 10 der ersten Ableitereinheit 1.

Dadurch kann gewährleistet werden, dass die erste Ableitereinheit 1 und insbesondere der zumindest eine erste Überspannungsableiter 10 nicht im Normalbetrieb zündet, also ohne beispielsweise eine durch einen Blitz hervorgerufene Überspannung schon bei normaler Netzspannung.

Die zweite Ableitereinheit 2 weist eine Ansprechspannung auf, die kleiner als die Netzspannung zwischen den Leitern 90 ist und damit kleiner als eine Netzspannung zum Betrieb des elektrischen Geräts oder des elektrischen Netzes. Da die erste Ableitereinheit 1 eine größere Ansprechspannung als die Netzspannung aufweist, findet jedoch unter Normalbedingungen keine Zündung eines Überspannungsableiters der Vorrichtung 100 statt. Im Fall einer Überspannung, beispielsweise durch einen Blitz, zündet der zumindest eine erste Überspannungsableiter 10 der ersten Ableitereinheit 1 und danach, aufgrund der geringeren Ansprechspannung, auf jeden Fall auch der zumindest eine zweite Überspannungsableiter 20 der zweiten Ableitereinheit 2, so dass der aus der Überspannung resultierende Blitzstromstoß wirksam zum Bezugspotenzialknoten 99 abgeleitet werden kann.

Weiterhin sind die erste Ableitereinheit 1 und die zweite Ableitereinheit 2 so ausgebildet, dass die zweite Ableitereinheit 2 eine größere Bogenbrennspannung als die erste Ableitereinheit 1 aufweist. Die im Vergleich zur zweiten Ableitereinheit 2 kleinere Bogenbrennspannung der ersten Ableitereinheit 1 kann kleiner als die Netzspannung sein, was ohne die zweite Ableitereinheit 2 nach der Zündung des zumindest einen Überspannungsableiters 10 der ersten Ableitereinheit 1 zur Bildung eines Netzfolgestroms zwischen dem ersten Potenzialknoten 91 und dem Bezugspotenzialknoten 99 führen würde. Da die zweite Ableitereinheit 2 so ausgebildet ist, dass deren Bogenbrennspannung größer als die der ersten Ableitereinheit 1 ist, kann durch die zweite Ableitereinheit 2 der Netzfolgestrom reduziert und besonders bevorzugt gelöscht werden. Die Kombination von unterschiedlichen Ableitereinheiten mit unterschiedlichen Eigenschaften ermöglicht es somit, die gewünschten Vorteile der einzelnen Ableitereinheiten in der Ableitungsvorrichtung 100 zu vereinen.

In den folgenden Figuren sind bevorzugte Ausführungsbeispiele für die Ausbildung der Vorrichtung 100 und insbesondere der ersten und zweiten Ableitereinheiten 1, 2 und deren Überspannungsableitern 10, 20 gezeigt.

Die Vorrichtung 100 weist gemäß dem Ausführungsbeispiel der Figur 2 eine erste Ableitereinheit 1 und eine zweite Ableitereinheit 2 auf, die zwischen dem ersten Potenzialknoten 91 und dem Bezugspotenzialknoten 99 in Reihe geschaltet sind. Die erste Ableitereinheit 1 weist im gezeigten Ausführungsbeispiel genau einen gasgefüllten Überspannungsableiter 10 auf, der eine Ansprechspannung aufweist, die größer als die Netzspannung zwischen dem ersten Potenzialknoten 91 und dem Bezugspotenzialknoten 99 ist.

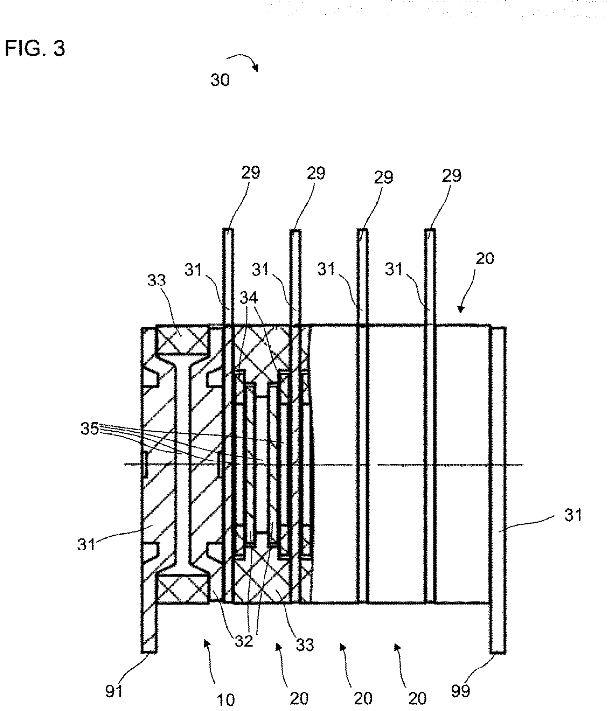

Die zweite Ableitereinheit 2 weist eine Mehrzahl von zweiten Überspannungsableitern 20 auf, die miteinander und mit dem erste Überspannungsableiter 10 in Reihe geschaltet sind. Die zweiten Überspannungsableiter 20 weisen eine Ansprechspannung auf, die niedriger als die Ansprechspannung des ersten Überspannungsableiters 10 und insbesondere auch niedriger als die Netzspannung ist. Rein beispielhaft sind vier zweite Überspannungsableiter 20 gezeigt. Es sind auch mehr oder weniger zweite Überspannungsableiter 20 möglich. Beispielsweise kann jeder der zweiten Überspannungsableiter 20 selbst wiederum ein Mehrstreckenableiter sein, beispielsweise mit drei integrierten Gasableitern, wie in Verbindung mit der Figur 3 beschrieben ist. Weiterhin weist die zweite Ableitereinheit 2 eine Triggerschaltung auf, die durch RC-Glieder 21 gebildet wird.

Insbesondere ist von Potenzialknoten 29 zwischen zwei benachbarten zweiten Überspannungsableitern 20 jeweils ein RC-Glied 21 zum Bezugspotenzialknoten 99 gekoppelt. Zusätzlich ist von einem Potenzialknoten 29 zwischen dem ersten Überspannungsableiter 10 und dem benachbarten zweiten Überspannungsableiter 20 ein RC-Glied 21 zum Bezugspotenzialknoten 99 gekoppelt, so dass jedem zweiten Überspannungsableiter 20 ein RC-Glied 21 zugeordnet ist. Sind die zweiten Überspannungsableiter 20 als Mehrstreckenableiter gebildet, also jeweils als Gruppe von Überspannungsableitern, so ist entsprechend jeder dieser Gruppen von Überspannungsableitern ein RC-Glied 21 zugeordnet.

Jedes der RC-Glieder 21 weist parallel zueinander geschaltet einen Kondensator 22 und einen Widerstand 23 auf. Die Triggerschaltung ist so ausgebildet, dass bei einem durch eine Überspannung an den Potenzialknoten 29 hervorgerufenen Stoßstrom bei dem entsprechenden RC-Glied 21 der jeweilige Kondensator 22 zuerst geladen wird, bis der zugeordnete zweite Überspannungsableiter 20 zündet, und dann über den jeweiligen Widerstand 23 besonders bevorzugt innerhalb weniger Millisekunden wieder entladen wird, so dass somit die Ansprechspannung niedrig gehalten wird. Jedes RC-Glied 21 ist direkt und insbesondere ohne weitere, zwischengeschaltete elektrische Komponente zum Bezugspotenzialknoten 99 gekoppelt. Beispielsweise können die RC-Glieder 21 derart ausgebildet sein, dass die Zeitkostante τ = R×C im Millisekundenbereich liegt, wobei C die Kapazität des Kondensators 22 und R der Nennwert des Widerstands 23 sind. Besonders bevorzugt ist τ ≤ 1 ms, beispielsweise 0,9 ms oder 0,5 ms.

Die Kondensatoren 22 weisen beispielsweise eine Kapazität C im Bereich von größer oder gleich 1 nF und kleiner oder gleich 40 nF auf. Mit höherer Kapazität C steigt die Durchschaltzeit, also die Reaktionszeit, des jeweiligen zweiten Überspannungsableiters 20, die Ansprechspannung sinkt. Die Widerstände 23 weisen beispielsweise einen Nennwert R im Bereich von größer oder gleich 1 kΩ und kleiner oder gleich 100 kΩ auf. Je kleiner der Widerstandswert ist, desto länger dauert das Laden des jeweils zugeordneten Kondensators 22 während eines Stromimpulses, die Durchschaltzeit steigt. Durch eine geeignete Kombination von Kondensatoren 22 und Widerständen 23 ist es somit möglich, die Anzahl der zweiten Überspannungsableiter 20 in der zweiten Ableitereinheit 2 im Vergleich zu einem Mehrstreckenableiter ohne Triggerschaltung zu erhöhen, ohne dass die Ansprechspannung zu hoch wird, während die Bogenbrennspannung erhöht und damit die Löscheigenschaften verbessert werden.

Wie beschrieben wird die Vorrichtung 100 gemäß dem Ausführungsbeispiel der Figur 2 bevorzugt mit und besonders bevorzugt aus den folgenden Teilen gebildet. Die erste Ableitereinheit 1 mit dem ersten Überspannungsableiter 10 bildet einen Gasableiter mit Trennfunktion, um die zweite Ableitereinheit 2 und damit die weiteren Gasableiter der Vorrichtung 100 von der Netzspannung zwischen dem ersten Potenzialknoten 91 und dem Bezugspotenzialknoten 99 zu trennen. Der erste Überspannungsableiter 10 weist bevorzugt ein robustes Design und eine stabile Ansprechspannung, insbesondere eine stabile Ansprechgleichspannung, auf, die größer als die Netzspannung ist. Die zweiten Überspannungsableiter 20 der zweiten Ableitereinheit 2 bilden einen Mehrstreckenableiter mit einer Folgestromlöschfunktion. Hierzu weist die zweite Ableitereinheit 2 zusätzlich die durch die RC-Glieder 21 gebildete Triggerschaltung auf, die eine Synchronzündung oder zumindest eine quasi-synchrone Zündung der Überspannungsableiter ermöglicht, was ebenfalls vorteilhaft ist, um dem Schutzpegel zu senken. Mit anderen Worten sind die zweiten Überspannungsableiter 20 und die Triggerschaltung gezielt so ausgebildet, dass die zweite Ableitereinheit 2 im Vergleich zur ersten Ableitereinheit 1 eine höhere Bogenbrennspannung aufweist, um einen Folgestrom zu löschen. Die Ansprechspannung und insbesondere die Ansprechgleichspannung der einzelnen zweiten Überspannungsableitern 20 ist dabei kleiner als die Netzspannung. Mit anderen Worten werden die Ansprechspannung und insbesondere die Ansprechgleichspannung der zweiten Überspannungsableiter 20 reduziert, um den bestmöglichen Schutzpegel zu erreichen. Insbesondere wird dadurch der Schutzpegel der Vorrichtung 100 im Vergleich zu einem Mehrstreckenableiter gesenkt, der zur Erhöhung der Bogenbrennspannung beispielsweise nur aus mehreren gleichartigen Gasableitern gebildet wird.

In Figur 3 ist in einer teilweisen Schnittdarstellung ein einstückiger Mehrstreckenableiter 30 für eine Vorrichtung 100 gemäß einem weiteren Ausführungsbeispiel gezeigt. Insbesondere kann der einstückige Mehrstreckenableiter 30 in der Vorrichtung 100 gemäß dem Ausführungsbeispiel der Figur 2 verwendet werden.

Der Mehrstreckenableiter 30 weist entsprechend der Vorrichtung 100 des vorherigen Ausführungsbeispiels den einen ersten Überspannungsableiter 10 der ersten Ableitereinheit und die vier zweiten Überspannungsableiter 20 der zweiten Ableitereinheit auf, wobei jeder zweite Überspannungsableiter 20 wiederum ein Mehrstreckenableiter mit drei integrierten Gasableitern ist. Entsprechend können die zweiten Überspannungsableiter 20 auch jeweils als Gruppe von Überspannungsableitern gesehen werden.

Zur Kontaktierung der Überspannungsableiter 10, 20 von außen an den Potenzialknoten 29, 91 und 99 weist der Mehrstreckenableiter 30 Elektroden 31 auf, die nach außengeführte Anschlüsse aufweisen, die die Potenzialknoten 29, 91 und 99 repräsentieren. Weiterhin weist der Mehrstreckenableiter 30 interne Elektroden 32 auf. Die Elektroden 31, 32 sind in einem Keramikgehäuse 33 angeordnet, das durch eine zusammenhängende Struktur oder durch ringförmige Bereiche zwischen den von außen kontaktierbaren Elektroden 31 gebildet wird.

Der erste Überspannungsableiter 10 weist wie gezeigt eine von außen kontaktierbare, den ersten Potenzialknoten 91 repräsentierende Elektrode 31 und eine interne Elektrode 32 auf, die im Hinblick auf die vorab beschriebenen Ableiteigenschaften verhältnismäßig massiv ausgebildet sind. Dadurch kann der erste Überspannungsableiter 10 hohe Blitzströme tragen, ohne seine Eigenschaften wie die Ansprechgleichspannung oder den Schutzpegel zu verändern. Zwischen den Elektroden 31, 32 des ersten Überspannungsableiters 10 ist umgeben vom Keramikgehäuse 33 ein Gasraum 35 ausgebildet.

Die zweiten Überspannungsableiter 20 weisen jeweils zwei von außen kontaktierbare, die Potenzialknoten 29 repräsentierende Elektroden 31 auf, zwischen denen jeweils zwei interne Elektroden 32 angeordnet sind, wobei die Elektroden 31, 32 der zweiten Überspannungsableiter 20 durch das Keramikgehäuse 33 und Abstandshalter 34 in Form von keramischen Distanzringen unter Ausbildung von Gasräumen 35 voneinander beabstandet angeordnet sind. Die vom ersten Überspannungsableiter 10 aus gesehen am weitesten entfernt angeordnete von außen kontaktierbare Elektrode 31 repräsentiert den Bezugspotentialknoten 99.

Die vorab beschriebenen Ableitereigenschaften der ersten und zweiten Überspannungsableiter 10, 20 können durch die Wahl des Materials, der Geometrie und den Abstand der Elektroden 31, 32 sowie durch das in den jeweiligen Gasräumen 35 enthaltene Gas und dessen jeweiligen Druck eingestellt werden. Insbesondere können in den Überspannungsableitern 10, 20 beispielsweise reine Edelgase oder Edelgasgemische verwendet werden, beispielsweise eines oder mehrere ausgewählt aus Ar, Ne, Kr, He, N₂. Besonders vorteilhafte Gemische mit in Klammern angegebenen Mischungsverhältnissen sind beispielsweise Ne/Ar/H₂ (41/41/18), Ne/Ar/H₂ (57/3/40), Ar/H₂ (80/20), Ar/H₂ (60/40), Ne/Ar (90/10). Vorteilhafte Druckbereiche können von größer oder gleich 0,1 bar bis kleiner oder gleich 2,5 bar reichen.

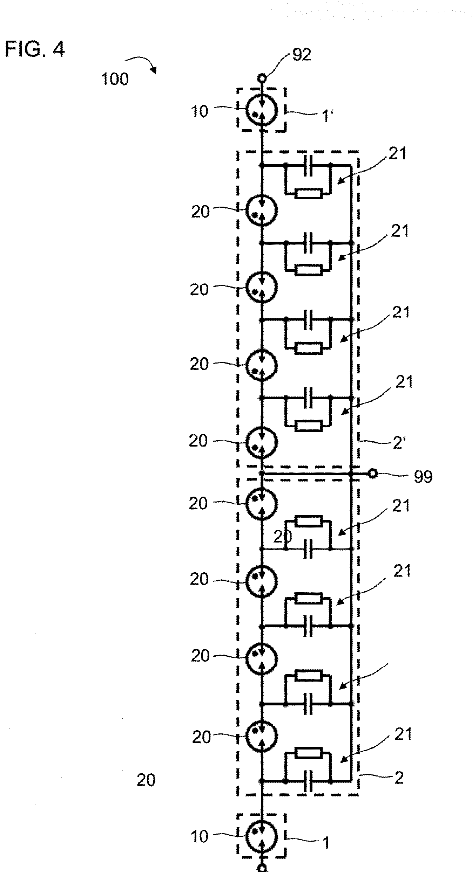

In Figur 4 ist die Vorrichtung 100 gemäß einem weiteren Ausführungsbeispiel gezeigt. Die Vorrichtung 100 weist eine erste Ableitereinheit 1 und eine zweite Ableitereinheit 2 auf, die zwischen einem ersten Potenzialknoten 91 und einem Bezugspotenzialknoten 99 in Reihe geschaltet sind. Insbesondere sind die erste und zweite Ableitereinheit 1, 2 wie im Ausführungsbeispiel der Figur 2 ausgebildet.

Weiterhin weist die Vorrichtung 100 eine weitere erste Ableitereinheit 1` mit zumindest einem ersten gasgefüllten Überspannungsableiter 10 und zumindest eine weitere zweite Ableitereinheit 2' mit zumindest einem zweiten gasgefüllten Überspannungsableiter 20 auf, wobei die weitere erste Ableitereinheit 1' und die weitere zweite Ableitereinheit 2' zwischen einem zweiten Potenzialknoten 92 und dem Bezugspotenzialknoten 99 miteinander in Reihe geschaltet sind. Der zweite Potenzialknoten 92 kann einer Phase bzw. einem L-Leiter entsprechen. Beispielsweise können der erste und zweite Potenzialknoten 91, 92 zwei Phasen entsprechen, also etwa L+ und L-, während der Bezugspotenzialknoten 99 einem Schutzleiter entspricht.

Die in Verbindung mit der Figur 2 für die erste und zweite Ableitereinheit 1, 2 sowie für den ersten und die zweiten Überspannungsableiter 10, 20 beschriebenen Merkmale gelten auch für die weitere erste Ableitereinheit 1' und die weitere zweite Ableitereinheit 2`. Besonders bevorzugt sind die erste Ableitereinheit 1 und die weitere erste Ableitereinheit 1` sowie die zweite Ableitereinheit 2 und die weitere zweite Ableitereinheit 2' jeweils gleich, so dass die in Figur 4 gezeigte Vorrichtung 100 symmetrisch zum Bezugspotenzialknoten 99 aufgebaut ist.

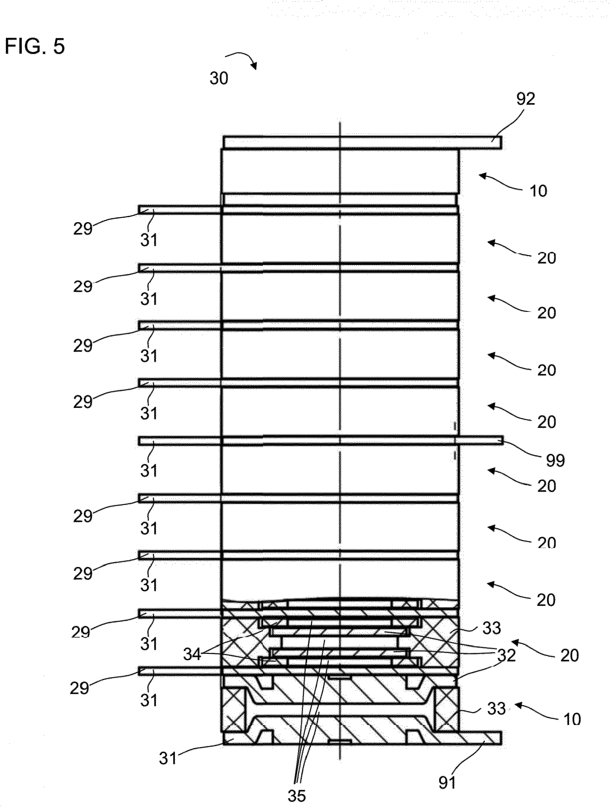

In Figur 5 ist ein Mehrstreckenableiter 30 für die Vorrichtung 100 gemäß dem Ausführungsbeispiel der Figur 4 gezeigt, der analog zum Mehrstreckenableiter 30 des Ausführungsbeispiels der Figur 3 aufgebaut ist. Insbesondere sind die Überspannungsableiter 10, 20 der ersten und zweiten Ableitereinheit und die Überspannungsableiter 10, 20 der weiteren ersten und weiteren zweiten Ableitereinheit zusammen als einstückiger Mehrstreckenableiter 30 ausgebildet, so dass insbesondere alle Überspannungsableiter 10, 20 der Vorrichtung 100 des Ausführungsbeispiels der Figur 4 in einem gemeinsamen Bauelement integriert sind. Alternativ hierzu können die Überspannungsableiter 10, 20 der ersten und zweiten Ableitereinheit sowie die Überspannungsableiter 10, 20 der weiteren ersten und zweiten Ableitereinheit jeweils als Mehrstreckenableiter 30 gemäß dem Ausführungsbeispiel der Figur 3 ausgebildet sein, die miteinander verschaltet sind, und damit als mehrstückiger Mehrstreckenableiter. Wie in Figur 3 sind auch in Figur 5 die von den von außen kontaktierbaren Elektroden 31 repräsentierten Potenzialknoten 29, 91, 92, 99 angedeutet. Die einzelnen Teile und Komponenten des Mehrstreckenableiters 30 der Figur 5 entsprechen denjenigen des Mehrstreckenableiters 30 der Figur 3.

Die in den in Verbindung mit den Figuren beschriebenen Merkmale und Ausführungsbeispiele können gemäß weiteren Ausführungsbeispielen miteinander kombiniert werden, auch wenn nicht alle Kombinationen explizit beschrieben sind. Weiterhin können die in Verbindung mit den Figuren beschriebenen Ausführungsbeispiele alternativ oder zusätzlich weitere Merkmale gemäß der Beschreibung im allgemeinen Teil aufweisen.

Der Schutzumfang der Erfindung ist durch die beigelegten Patentansprüche definiert.

### Bezugszeichenliste

- 1, 1': Ableitereinheit
- 2, 2': Ableitereinheit
- 10: Überspannungsableiter
- 20: Überspannungsableiter
- 21: RC-Glied
- 22: Kondensator
- 23: Widerstand
- 29: Potenzialknoten
- 30: Mehrstreckenableiter
- 31: Elektrode
- 32: Elektrode
- 33: Keramikgehäuse
- 34: Abstandshalter
- 35: Gasraum
- 90: Leiter
- 91: erster Potenzialknoten
- 92: zweiter Potenzialknoten
- 99: Bezugspotenzialknoten
- 100: Vorrichtung

## Patentansprüche

1. Vorrichtung (100) zur Ableitung von Überspannungen, aufweisend
- eine erste Ableitereinheit (1) mit zumindest einem ersten gasgefüllten Überspannungsableiter (10) und
- eine zweite Ableitereinheit (2) mit zumindest einem zweiten gasgefüllten Überspannungsableiter (20),
wobei
- die erste und zweite Ableitereinheit zwischen einem ersten Potenzialknoten (91) und einem Bezugspotenzialknoten (99) miteinander in Reihe geschaltet sind,
- der erste Überspannungsableiter und der zweite Überspannungsableiter unterschiedlich sind, und
- die erste Ableitereinheit eine größere Ansprechspannung aufweist als die zweite Ableitereinheit, **dadurch gekennzeichnet, dass**
- die erste Ableitereinheit eine kleinere Bogenbrennspannung aufweist als die zweite Ableitereinheit.

2. Vorrichtung nach Anspruch 1, wobei die erste Ableitereinheit genau einen ersten Überspannungsableiter aufweist.

3. Vorrichtung nach einem der vorherigen Ansprüche, wobei die zweite Ableitereinheit eine Mehrzahl von zweiten Überspannungsableitern aufweist, die miteinander in Reihe geschaltet sind.

4. Vorrichtung nach einem der vorherigen Ansprüche, wobei alle Überspannungsableiter der ersten und zweiten Ableitereinheit in Reihe miteinander geschaltet sind.

5. Vorrichtung nach einem der vorherigen Ansprüche, wobei von einem Potenzialknoten (29) zwischen zwei benachbarten zweiten Überspannungsableitern jeweils ein RC-Glied (21) mit parallel geschaltetem Kondensator (22) und Widerstand (23) zum Bezugspotenzialknoten gekoppelt ist.

6. Vorrichtung nach einem der vorherigen Ansprüche, wobei von einem Potenzialknoten (29) zwischen einem ersten Überspannungsableiter und einem benachbarten zweiten Überspannungsableiter ein RC-Glied mit parallel geschaltetem Kondensator und Widerstand zum Bezugspotenzialknoten gekoppelt ist.

7. Vorrichtung nach Anspruch 5 oder 6, wobei jedem zweiten Überspannungsableiter ein RC-Glied zugeordnet ist.

8. Vorrichtung nach einem der Ansprüche 5 bis 7, wobei jedes RC-Glied direkt zum Bezugspotenzialknoten gekoppelt ist.

9. Vorrichtung nach einem der vorherigen Ansprüche, wobei die Überspannungsableiter der ersten und zweiten Ableitereinheit zusammen als einstückiger Mehrstreckenableiter (30) ausgebildet sind.

10. Vorrichtung nach einem der vorherigen Ansprüche, wobei
- die Vorrichtung eine weitere erste Ableitereinheit (1`) mit zumindest einem ersten gasgefüllten Überspannungsableiter und zumindest eine weitere zweite Ableitereinheit (2') mit zumindest einem zweiten gasgefüllten Überspannungsableiter aufweist,
- die weitere erste Ableitereinheit und die weitere zweite Ableitereinheit zwischen einem zweiten Potenzialknoten (92) und dem Bezugspotenzialknoten miteinander in Reihe geschaltet sind und
- die ersten Ableitereinheiten gleich sind und die zweiten Ableitereinheiten gleich sind.

11. Vorrichtung nach dem vorherigen Anspruch, wobei die Überspannungsableiter der ersten und zweiten Ableitereinheit und die Überspannungsableiter der weiteren ersten und weiteren zweiten Ableitereinheit zusammen als einstückiger Mehrstreckenableiter ausgebildet sind.

12. Vorrichtung nach Anspruch 10, wobei die
Überspannungsableiter der ersten und zweiten Ableitereinheit und die Überspannungsableiter der weiteren ersten und weiteren zweiten Ableitereinheit als mehrstückiger Mehrstreckenableiter ausgebildet sind.

13. Verwendung einer Vorrichtung (100) zur Ableitung von Überspannungen nach einem der vorhergehenden Ansprüche in einem elektrischen Gerät oder in einem elektrischen Netz.

14. Verwendung nach dem vorherigen Anspruch, wobei die erste Ableitereinheit eine Ansprechspannung aufweist, die größer ist als eine Netzspannung zum Betrieb des elektrischen Geräts oder des elektrischen Netzes.

## Claims

1. Device (100) for discharging overvoltages, having
- a first arrester unit (1) comprising at least one first gas-filled surge arrester (10), and
- a second arrester unit (2) comprising at least one second gas-filled surge arrester (20),
wherein
- the first and second arrester units are connected in series with one another between a first potential node (91) and a reference potential node (99),
- the first surge arrester and the second surge arrester are different, and
- the first arrester unit has a greater response voltage than the second arrester unit, **characterized in that**
- the first arrester unit has a lower arc burning voltage than the second arrester unit.

2. Device according to Claim 1, wherein the first arrester unit has exactly one first surge arrester.

3. Device according to either of the preceding claims, wherein the second arrester unit has a plurality of second surge arresters that are connected in series with one another.

4. Device according to one of the preceding claims, wherein all of the surge arresters of the first and second arrester units are connected in series with one another.

5. Device according to one of the preceding claims, wherein a respective RC element (21) comprising a capacitor (22) and a resistor (23) connected in parallel is coupled to the reference potential node by a potential node (29) between two adjacent second surge arresters.

6. Device according to one of the preceding claims, wherein an RC element comprising a capacitor and a resistor connected in parallel is coupled to the reference potential node by a potential node (29) between a first surge arrester and an adjacent second surge arrester.

7. Device according to Claim 5 or 6, wherein an RC element is assigned to each second surge arrester.

8. Device according to one of Claims 5 to 7, wherein each RC element is directly coupled to the reference potential node.

9. Device according to one of the preceding claims, wherein the surge arresters of the first and second arrester units are formed together as an integral multi-section arrester (30).

10. Device according to one of the preceding claims, wherein
- the device has a further first arrester unit (1') comprising at least one first gas-filled surge arrester and at least one further second arrester unit (2') comprising at least one second gas-filled surge arrester,
- the further first arrester unit and the further second arrester unit are connected in series with one another between a second potential node (92) and the reference potential node, and
- the first arrester units are the same and the second arrester units are the same.

11. Device according to the preceding claim, wherein the surge arresters of the first and second arrester units and the surge arresters of the further first and further second arrester units are formed together as a single-part multi-section arrester.

12. Device according to Claim 10, wherein the surge arresters of the first and second arrester units and the surge arresters of the further first and further second arrester units are formed as a multi-part multi-section arrester.

13. Use of a device (100) for discharging overvoltages according to one of the preceding claims in an electrical device or in an electrical network.

14. Use according to the preceding claim, wherein the first arrester unit has a response voltage that is greater than a line voltage for operating the electrical device or the electrical network.

## Revendications

1. Dispositif (100) permettant de dissiper des surtensions, présentant
- une première unité de protection contre les surtensions (1) pourvue d'au moins un premier parasurtenseur à gaz (10), et
- une deuxième unité de protection contre les surtensions (2) pourvue d'au moins un deuxième parasurtenseur à gaz (20),
dans lequel
- la première et la deuxième unité de protection contre les surtensions sont connectées en série l'une à l'autre entre un premier noeud de potentiel (91) et un noeud de potentiel de référence (99),
- le premier parasurtenseur et le deuxième parasurtenseur sont différents, et
- la première unité de protection contre les surtensions présente une plus grande tension de réponse que la deuxième unité de protection contre les surtensions,
**caractérisé en ce que**
- la première unité de protection contre les surtensions présente une tension de décharge disruptive inférieure à celle de la deuxième unité de protection contre les surtensions.

2. Dispositif selon la revendication 1, dans lequel la première unité de protection contre les surtensions présente exactement un premier parasurtenseur.

3. Dispositif selon l'une quelconque des revendications précédentes, dans lequel la deuxième unité de protection contre les surtensions présente une pluralité de deuxièmes parasurtenseurs qui sont connectés en série les uns aux autres.

4. Dispositif selon l'une quelconque des revendications précédentes, dans lequel tous les parasurtenseurs de la première et de la deuxième unité de protection contre les surtensions sont connectés en série les uns avec les autres.

5. Dispositif selon l'une quelconque des revendications précédentes, dans lequel respectivement un circuit RC (21) à condensateur (22) et résistance (23) connectés en parallèle est couplé au noeud de potentiel de référence à partir d'un noeud de potentiel (29) entre deux deuxièmes parasurtenseurs voisins.

6. Dispositif selon l'une quelconque des revendications précédentes, dans lequel un circuit RC à condensateur et résistance connectés en parallèle est couplé au noeud de potentiel de référence à partir d'un noeud de potentiel (29) entre un premier parasurtenseur et un deuxième parasurtenseur voisin.

7. Dispositif selon la revendication 5 ou 6, dans lequel un circuit RC est associé à chaque deuxième parasurtenseur.

8. Dispositif selon l'une quelconque des revendications 5 à 7, dans lequel chaque circuit RC est couplé directement au noeud de potentiel de référence.

9. Dispositif selon l'une quelconque des revendications précédentes, dans lequel les parasurtenseurs de la première et de la deuxième unité de protection contre les surtensions sont réalisés ensemble comme un parasurtenseur multivoies (30) d'un seul tenant.

10. Dispositif selon l'une quelconque des revendications précédentes, dans lequel
- le dispositif présente au moins une autre première unité de protection contre les surtensions (1') pourvue d'au moins un premier parasurtenseur à gaz et au moins une autre deuxième unité de protection contre les surtensions (2') pourvue d'au moins un deuxième parasurtenseur à gaz,
- l'autre première unité de protection contre les surtensions et l'autre deuxième unité de protection contre les surtensions sont connectées en série l'une à l'autre entre un deuxième noeud de potentiel (92) et le noeud de potentiel de référence, et
- les premières unités de dissipation sont identiques et les deuxièmes unités de dissipation sont identiques.

11. Dispositif selon la revendication précédente, dans lequel les parasurtenseurs de la première et de la deuxième unité de protection contre les surtensions et les parasurtenseurs de l'autre première et de l'autre deuxième unité de protection contre les surtensions sont réalisés ensemble comme un parasurtenseur multivoies d'un seul tenant.

12. Dispositif selon la revendication 10, dans lequel les parasurtenseurs de la première et de la deuxième unité de protection contre les surtensions et les parasurtenseurs de l'autre première et de l'autre deuxième unité de protection contre les surtensions sont réalisés comme un parasurtenseur multivoies d'un seul tenant.

13. Utilisation d'un dispositif (100) permettant de dissiper des surtensions selon l'une quelconque des revendications précédentes dans un appareil électrique ou dans un réseau électrique.

14. Utilisation selon la revendication précédente, dans lequel la première unité de protection contre les surtensions présente une tension de réponse qui est supérieure à une tension de réseau pour faire fonctionner l'appareil électrique ou le réseau électrique.
